# FASCICULE DE BREVET EUROPEEN

(11) **EP 1 567 611 B1**
(45) Date de publication et mention de la délivrance du brevet: **02.04.2008**
(21) Numéro de dépôt: 03782549.4
(22) Date de dépôt: 13.11.2003
(51) Int. Cl.: C09K 11/00, C01F 17/00, C30B 29/12

(54) **PREPARATION DE BLOCS D'HALOGENURE DE TERRE RARE, BLOCS AINSI OBTENUS, LEUR UTILISATION POUR FABRIQUER DES MONOCRISTAUX ET MONOCRISTAUX AINSI OBTENUS**
HERSTELLUNG VON BLOCKFORMEN AUS EINEM SELTNERERDHALOGENID, DADURCH HERGESTELLTE BLOCKFORMEN, IHRE VERWENDUNG ZUR HERSTELLUNG VON EINKRISTALLEN UND DADURCH HERGESTELLTE EINKRISTALLE
METHOD FOR PREPARING RARE-EARTH HALIDE BLOCKS, BLOCKS OBTAINED AND THEIR USE TO FORM SINGLE CRYSTALS AND SINGLE CRYSTALS OBTAINED THEREBY.

(30) Priorité: 27.11.2002 FR 0214856
(43) Date de publication de la demande: 31.08.2005
(73) Titulaire: Saint-Gobain Cristaux & Detecteurs, 92400 Courbevoie (FR)
(72) Inventeur: ILTIS, Alain, F-77690 Montigny sur Loing (FR)
(74) Mandataire: Colombier, Christian
(86) Numéro de dépôt international: PCT/FR2003/003356
(87) Numéro de publication internationale: WO 2004/050792

(56) Documents cités:
- WO-A-01/60944
- WO-A-01/60945
- US-A- 5 478 498
- US-B1- 6 451 106
- PATENT ABSTRACTS OF JAPAN vol. 018, no. 437 (C-1238), 16 août 1994 (1994-08-16) & JP 06 135715 A (MITSUBISHI MATERIALS CORP), 17 mai 1994 (1994-05-17)
- ANDRIESSEN J ET AL: "Experimental and theoretical study of the spectroscopic properties of Cedoped LaCl3 single crystals" OPTICS COMMUNICATIONS, NORTH-HOLLAND PUBLISHING CO. AMSTERDAM, NL, vol. 178, no. 4-6, mai 2000 (2000-05), pages 355-363, XP004204283 ISSN: 0030-4018
- MEYER ET AL.: "The ammonium chloride route to anhydrous rare earth chlorides- the example of YCl3" INORG. SYNTH., vol. 25, - 1989 pages 146-150, XP008021415
- MEYER AT AL: "The ammonium bromide route to anhydrous rare earth bromides MBr3" JOURNAL OF THE LESS COMMON METALS, vol. 127, 1987, pages 155-160, XP008021446 cité dans la demande
- EGGER P ET AL: "Czochralski growth of Ba2Y1-xErxCl7 (0<x=<1) using growth equipment integrated into a dry-box" JOURNAL OF CRYSTAL GROWTH, NORTH-HOLLAND PUBLISHING CO. AMSTERDAM, NL, vol. 200, no. 3-4, avril 1999 (1999-04), pages 515-520, XP004168216 ISSN: 0022-0248

## Description

Les halogénures de terre rare (dans ce qui suit, on utilise Ln pour désigner une terre rare), notamment lorsqu'ils sont dopés au cérium, et en particulier LnBr₃ dopé au Cerium et LnCl₃ dopé au Cerium présentent des propriétés de scintillation très intéressantes notamment pour des applications en imagerie nucléaire et en spectroscopie (Positron-Emission-Tomography dit PET, Gamma caméra, prospection petrolière et autre). Pour obtenir de façon satisfaisante ces propriétés, il faut obtenir ces composés sous forme de cristaux de grandes dimensions. Généralement, ces cristaux sont des monocristaux. Dans certains cas particuliers ils peuvent également être des polycristaux à l'intérieur desquels les cristaux ont une dimension de l'ordre d'un ou plusieurs centimètres. Cependant, les halogénures de terre rare sont des composés très hygroscopiques qui réagissent avec l'eau et avec l'air dès qu'ils sont chauffés pour former des oxyhalogénures très stables. Il a en général été considéré que des taux d'oxyhalogénure de l'ordre de 0,1% en poids étaient acceptables, les cristaux obtenus à ces teneurs étant en apparence suffisamment transparents. De plus, certains cristaux comme le Csl :Tl s'accommodent de fortes teneurs en oxygène (par exemple autour de 0,2% de CsOH) pour autant que les propriétés de scintillation sont concernées. Or la demanderesse a découvert que les propriétés de scintillation, notamment le rendement lumineux c'est à dire le nombre de photons UV-Visibles émis par MeV d'énergie d'une particule incidente,des halogénures de terre rare pouvaient être drastiquement améliorées en faisant baisser le taux d'oxyhalogénure dans un cristal d'halogénure de terre rare en dessous de cette valeur.

La demanderesse a donc cherché à mettre au point des procédés de fabrication menant aux halogénures de terre rare les plus purs possible (notamment en oxygène), c'est-à-dire dont la teneur en eau est très inférieure à 0,1 % en poids et la teneur en oxyhalogénures est inférieure à 0,2 % en poids, et même inférieure à 0,1% en poids, voire inférieure à 0,05 % en poids. Par ailleurs, il faut trouver des moyens de conservation (par exemple sur quelques mois) et de manipulation de ces halogénures qui permettent le maintien de cette pureté. En effet, la croissance des cristaux (généralement monocristaux) est habituellement réalisée en discontinu (« batch » en anglais) ce qui implique des phases de stockage et de déstockage favorisant la pollution de l'halogénure de terre rare par l'eau et l'oxygène de l'air.

De plus, il est très difficile de réaliser une installation de préparation d'halogénure de terre rare (en tant que matière première pour la croissance de cristaux, généralement monocristaux) qui n'apporte pas elle-même un peu d'eau ou d'oxygène menant à la formation d'oxyhalogénure indésirable. En effet, toute installation est toujours plus ou moins étanche et d'autre part contient toujours un peu d'eau adsorbée, de sorte qu'une pollution partielle est habituelle dans ce genre de préparation, et l'on s'attend généralement à une forte oxydation par les impuretés de l'environnement gazeux, surtout aux fortes températures comme au-dessus de 300°C. L'invention apporte également une solution de ce point de vue puisque le procédé selon l'invention mène à un halogénure de terre rare très pur, même avec une installation contenant au départ de l'eau, adsorbée, absorbée, ou en phase condensée, et même en présence d'un taux raisonnable d'eau et d'oxygène dans l'atmosphère pendant le chauffage menant à la fusion.

La demanderesse a découvert que les cristaux fabriqués selon l'invention pouvaient même avoir des points de fusion sensiblement éloignés de ceux mentionnés dans la littérature, ceci étant interprété comme un effet de la haute pureté des cristaux (notamment une faible teneur en oxychlorure) obtenu gràce à l'invention. Ainsi, un LaCl₃ réalisé selon l'invention présente une température de cristallisation de 880°C alors que les valeurs publiées par l'art antérieur s'échellonent entre 852 et 860°C. De même, un LaBr₃ fabriqué selon l'invention présente une température de cristallisation de 820°C, alors que les valeurs publiées dans l'art antérieur sont comprises entre 777°C et 789°C.

L'invention permet notamment la préparation de monocristaux présentant un particulièrement faible temps de décroissance de scintillation. On cherche en effet des cristaux dont les pics de scintillation présentent un temps de décroissance le plus faible possible, car ainsi la résolution temporelle est améliorée. Pour faire cette mesure, on enregistre l'intensité lumineuse du pic principal au fil de temps. Ainsi, l'invention permet la réalisation de monocristaux dont le temps de décroissance de la composante principale est inférieur à 40, et même inférieur à 30 et même inférieur à 20 nanosecondes.Dans le cadre de la présente demande, X représente un atome d'halogène choisi parmi Cl, Br, I. Les fluorures de terre rare ne sont pas concernés par la présente invention compte tenu de ce qu'ils ne sont pas hygroscopiques et compte tenu de ce que leur chimie est très spécifique.

Les monocristaux préparés selon l'invention présentent également une résolution en énergie particulièrement basse, notamment inférieure à 5%, voire inférieure à 4%, voire inférieure à 3,5%.

Pour préparer un halogénure de terre rare, on peut avoir conventionnellement recours aux procédés suivants :
1. déshydratation sous vide à 80°C de LaX₃(H₂O)₇ : mais ce procédé donne des teneurs en LaOX trop élevées et mène à des cristaux de moindre qualité;
2. chloration de La₂O₃ solide par HCl gazeux à plus de 500°C : ce procédé est dangeureux car il nécessite l'utilisation de grandes quantités de HCl gazeux, gaz toxique, et de plus il est très difficile industriellement de s'assurer que la réaction de chloration soit complete ;
3. déshydratation de LaX₃(H₂O)₇ sous HX gazeux. Ce procédé est également dangereux en raison des importantes quantités de HX à utiliser ;
4. réaction d'une poudre de La₂O₃ avec un NH₄Cl gazeux à 340°C environ : il est très difficile industriellement de s'assurer que la réaction de chloration soit complete.

Le document « the ammonium-bromide route to anhydrous rare earth bromides MBr3 ; J. of the Less-common Metals, 127 (1987) 155-160» enseigne la préparation d'un complexe halogénure de terre rare / bromure d'ammonium et sa décomposition thermique à moins de 20°C/heure pour former un halogénure de terre rare, mais sans jamais atteindre la fusion. En procédant de la sorte, l'halogénure conserve une forte surface spécifique, supérieure à 0,1 m²/g propice à l'absorption d'humidité et à la formation d'oxychlorure. Le fait de travailler à moins de 400°C limite grandement les problèmes de corrosion des matériaux, et c'est une des raisons pour lesquelles il est préféré dans l'art antérieur d'utiliser de telles basses températures.L'art antérieur faisant usage de composés du type NH₄X ne chauffe généralement pas au delà de 300 ou 400°C car aux plus hautes températures le NH₄X a disparu par sublimation et l'halogénure de terre rare devrait être particulièrement sensible à l'oxydation à partir des traces d'eau et d'oxygène présentes dans l'environnement gazeux.

Comme documents de l'art antérieur, on peut encore citer les WO 0160944, WO0160945 et US 6451106.

L'invention résout les problèmes susmentionnés. L'invention permet l'obtention d'un halogénure de terre rare très pur sous forme de bloc polycristallin, présentant notamment une teneur en oxyhalogénure de terre rare inférieure à 0,2 % en poids, voire inférieure à 0,1% en poids, voire inférieure à 0,05 % en poids, voire inférieure à 0,02 % en poids et une teneur en eau inférieure à 0,1 % en poids.

Le procédé de préparation selon la revendication 1 et selon l'invention comprend une étape de chauffage d'un mélange d'une part d'au moins un composé comprenant au moins une liaison Ln-X et d'autre part de NH₄X, dans lesquelles Ln représente une terre rare et X est choisi parmi Cl, Br et I, ledit composé et NH₄X pouvant être combinés au moins partiellement au sein d'un complexe, ladite étape menant à une phase fondue comprenant l'halogénure visé, puis une étape de refroidissement menant à au moins un bloc solide comprenant ledit halogénure. Le NH₄X, en réagissant avec les oxyhalogénures, joue le rôle de piégeur (« scavenger » en anglais) d'oxygène et débarrasse de ce fait l'halogénure de terre rare de ses oxychlorures, étant entendu que ces oxychlorures peuvent provenir de la réaction entre l'eau absorbée par l'halogénure de terre rare et l'halogénure de terre rare au cours du chauffage. Cette purification se fait sur le principe de la réaction suivante :

LnOX + 2 NH₄X → LnX₃ + H₂O + 2 NH₃

Le procédé selon l'invention permet notamment d'éviter que l'eau présente dans le mélange ou le creuset ou l'appareillage, sous forme adsorbée, absorbée ou complexée, ne se combine de façon définitive en oxychlorure de terre rare avec l'halogénure de terre rare. Ainsi, le procédé selon l'invention mène à un bloc final présentant beaucoup moins d'oxyhalogénure que le même procédé sans NH₄X au départ. Notamment, cela peut-être observé avec une installation difficile à débarrasser de son eau adsorbée, c'est-à-dire une installation aboutissant habituellement à un fort taux d'oxyhalogénure (par exemple au moins 0,2% d'oxyhalogénure) dans l'halogénure final même lorsque l'on ne met pas volontairement d'oxyhalogénure dans le mélange de départ (ou un taux très faible, soit moins de 100 ppm en poids) et même en présence des teneurs habituelles pour ce genre de fabrication en eau et en oxygène dans l'environnement gazeux.

Le bloc polycristallin obtenu selon l'invention et selon la revendication 19 est très pur. L'invention combine en une seule étape de chauffage l'action de piégeage d'oxygène conféré par la présence de l'halogénure d'ammonium, et le fait d'aller immédiatement jusqu'à la fusion de l'halogénure de terre rare de façon à faire diminuer drastiquement sa surface spécifique, ce qui le rend d'autant moins sensible à l'humidité lors de son stockage et sa manipulation. L'halogénure est donc dans un premier temps purifié, pour être dans un deuxième temps fondu de façon à devenir beaucoup moins sensible à l'oxydation par l'eau et l'oxygène, ce premier et deuxième temps étant réalisés dans une seule et même étape de chauffage, ce qui signifie qu'une fois que le mélange à atteint la température de 300 °C, on ne fait pas revenir sa température à la température ambiante ni même à une température inférieure à 200°C avant d'avoir atteint la fusion de l'halogénure de terre rare souhaité. Cette préparation du bloc selon l'invention est réalisée sous atmosphère inerte ou neutre (azote ou argon par exemple) mais cette atmosphère peut même contenir de relativement fortes teneurs en eau et oxygène, c'est-à-dire de sorte que la somme des masses d'eau et d'oxygène dans l'atmosphère gazeuse soit inférieure à 200 ppm en poids. Généralement, pendant la réalisation du bloc selon l'invention, la teneur de l'atmosphère inerte en eau va de 10 à 180 ppm en poids et la teneur de l'atmosphère en oxygène va de 0,5 à 2 ppm en poids.

En raison de sa faible surface spécifique, comparé à une poudre, le bloc absorbe moins les impuretés de l'air (humidité et oxygène) et peut de ce fait être stocké et manipulé en conservant un état très pur. Dans ces conditions, ce bloc peut servir à la préparation de cristaux (généralement monocristaux) d'halogénures de terre rare très purs et de grande qualité.

L'invention concerne également un procédé de préparation des blocs selon l'invention dans un creuset riche en carbone. Alors que selon l'art antérieur comme par exemple l'article de P. Egger et al, J.Crystal Growth 200 (1999) 515-520, la croissance de Ba₂Y₁₋ₓErₓCl₇ (o<x<1) dans un creuset en carbone vitreux mène à une pollution du cristal à cause du creuset, il s'est avéré que les compositions faisant l'objet de la présente invention étaient avantageusement fondues dans un creuset riche en carbone comme c'est le cas du carbone vitreux, pour réaliser le bloc selon l'invention.

Les terres rares Ln concernées par la présente invention sont celles de la colonne 3 (selon la nouvelle notation) du tableau périodique des éléments, incluant Sc, Y, La, et les Lanthanides de Ce à Lu. Sont plus particulièrement concernés les halogénures de Y, La, Gd et Lu, pouvant notamment être dopés au Ce ou Pr.

Les halogénures de terre rare plus particulièrement concernés pour être fabriqués en bloc selon la présente invention peuvent être représentés par la formule générale AₑLn_{f}X_{(3f+e)} dans laquelle Ln représente une ou plusieurs terre(s) rare(s), X représente un ou plusieur(s) atome(s) d'halogène choisi parmi Cl, Br ou I, et A représente un ou plusieurs alcalin(s) comme K, Li, Na, Rb ou Cs, e et f représentant des valeurs telles que
- e, pouvant être nul, est inférieur où égal à 3f,
- f est supérieur ou égal à 1.

Le procédé selon l'invention est d'autant plus efficace que le numéro atomique de X est faible. Ainsi, l'efficacité du procédé selon l'invention à réduire le taux d'oxyhalogénure dans le bloc final va, en fonction de la nature de X, dans le sens croissant suivant : I < Br < Cl. Le procédé selon l'invention est d'autant plus efficace que le rayon ionique de Ln est important. Ainsi, l'efficacité du procédé selon l'invention à réduire le taux d'oxyhalogénure dans le bloc final va, en fonction de la nature de Ln, dans le sens croissant suivant : Sc < Lu < Y < Gd < Pr < Ce < La.

Les halogénures de terre rare plus particulièrement concernés sont notamment les suivants :
- ALn₂X₇ dans laquelle Ln représente une ou plusieurs terre rare(s), X représente un ou plusieur(s) atome(s) d'halogène choisi parmi Cl, Br ou I, A représentant un alcalin comme Rb et Cs,
- LaCl₃ pouvant notamment être dopé par 0,1 à 50 % en poids de CeCl₃,
- LnBr₃ pouvant notamment être dopé par 0,1 à 50 % en poids de CeBr₃,
- LaBr₃ pouvant notamment être dopé par 0,1 à 50 % en poids de CeBr₃,
- GdBr₃ pouvant notamment être dopé par 0,1 à 50 % en poids de CeBr₃,
- LaₓLn₍₁₋ₓ₎X₃ pouvant notamment être dopé par 0,1 à 50 % de CeX₃, x pouvant aller de 0 à 1, Ln étant une terre rare différente de La, X étant un halogène comme précédemment dit,
- LaₓGd₍₁₋ₓ₎Br₃ pouvant notamment être dopé par 0,1 à 50 % de CeBr₃, x pouvant aller de 0 à 1,
- LaₓLu(₁₋ₓ₎Br₃ pouvant notamment être dopé par 0,1 à 50 % de CeBr₃, x pouvant aller de 0 à 1,
- Ln'ₓLn"₍₁₋ₓ₎X'_{3(1-y)}X"_{3y} dans laquelle Ln' et Ln" sont deux terres rares différentes du type Ln, X' et X" étant deux halogènes différents du type X, notamment Cl et Br, x pouvant aller de 0 à 1, y pouvant aller de 0 à 1,
- RbGd₂Br₇ pouvant notamment être dopé par 0,1 à 50 % en poids de CeBr₃,
- RbLn₂Cl₇ pouvant notamment être dopé par 0,1 à 50 % en poids de CeCl₃,
- RbLn₂Br₇ pouvant notamment être dopé par 0,1 à 50 % en poids de CeBr₃,
- CsLn₂Cl₇ pouvant notamment être dopé par 0,1 à 50 % en poids de CeCl₃,
- CsLn₂Br₇ pouvant notamment être dopé par 0,1 à 50 % en poids de CeBr₃,
- K₂LaCl₅ pouvant notamment être dopé par 0,1 à 50 % en poids de CeCl₃.
- K₂Lal₅ pouvant notamment être dopé par 0,1 à 50 % en poids de Cel₃.

Le terme « dopant » ou « dopé » se réfère à une terre rare minoritaire se substituant à une ou plusieurs terres rares majoritaires, les minoritaires et majoritaires étant compris sous le sigle Ln.

Ainsi, l'invention peut notamment mener à un bloc dans lequel Ln est La ou Ce et X est Cl ou Br.

L'invention concerne notamment un procédé de préparation d'un bloc caractérisé en ce qu'il comprend une étape de chauffage d'un mélange d'une part d'au moins un composé comprenant au moins une liaison Ln-X et d'autre part de NH₄X, ledit composé et NH₄X pouvant être combinés au moins partiellement au sein d'un complexe, ladite étape menant à une masse fondue comprenant l'halogénure de formule AₑLn_{f}X_{(3f+e)}, ladite étape de chauffage étant suivie d'une étape de refroidissement après l'obtention de la masse fondue, ladite étape de chauffage, après avoir atteint 300°C ne redescendant jamais en dessous de 200°C avant l'obtention de ladite masse fondue.

Le composé comprenant au moins une liaison Ln-X peut être de formule AᵣLnₛOᵤXᵣ₊₃ₛ₋₂ᵤ dans laquelle A, X et Ln ont la signification déjà donnée, r,s et u représentant des valeurs entières ou non entières vérifiant les conditions suivantes de façon cumulative :
r pouvant aller de 0 à 2s,
s étant supérieur ou égal à 1,
u pouvant aller de 0 à s,
ce composé pouvant être complexé ou non complexé avec de l'eau ou du NH₄X.

Dans le composé comprenant au moins une liaison Ln-X, Ln a le degré d'oxydation 3 et, s'il est présent, A a le degré d'oxydation 1. Notamment, r peut être nul. Notamment, u peut être nul.

De préférence, dans le composé comprenant au moins une liaison Ln-X, la quantité d'oxygène lié à Ln est telle que la quantité d'oxyhalogénure obtenue par la méthode de dissolution est inférieure à 100 ppm en poids.

Le composé comprenant au moins une liaison Ln-X peut être un halogénure de terre rare ou un halogénure de terre rare hydraté. Il peut par exemple être de formule LnX₃ ou LnX₃.(H₂O)ₙ avec n allant de 1 à 10, ou un mélange de plusieurs des composés dont les formules viennent d'être données.

Le composé comprenant au moins une liaison Ln-X peut également être un oxyhalogénure de terre rare. Il peut être de formule LnXO ou un mélange de plusieurs des composés dont les formules viennent d'être données. On préfère éviter la présence de LnXO dans le mélange de départ. Ainsi, de préférence, le mélange de départ contient moins de 100 ppm en poids de LnXO. En général, il s'agit d'un halogénure de terre rare en poudre contenant une faible proportion d'oxyhalogénure et d'eau. Le mélange peut également comprendre un complexe d'un oxyhalogénure de terre rare et de NH₄X.

Le mélange peut également comprendre de l'eau, sous forme libre ou sous forme complexée, par exemple avec l'halogénure de terre rare. De façon étonnante, la quantité d'eau peut être très importante, sans que cela ne se traduise par l'obtention d'un taux d'oxyhalogénure plus important dans le bloc polycristallin final selon l'invention, dès lors que le mélange contient une quantité suffisante de NH₄X.

Le mélange peut même comprendre par exemple jusqu'à 20 % en poids d'eau, voire plus. Il peut également comprendre par exemple moins de 16 % en poids d'eau, voire moins de 5 % en poids d'eau.

Le mélange d'une part d'au moins un composé comprenant au moins une liaison Ln-X et d'autre part de NH₄X, ces deux composés étant le cas échéant au moins partiellement sous forme complexée, comprend suffisamment de NH₄X pour que le bloc final comprenne moins de 0,2 % en poids d'oxyhalogénure de terre rare, voire moins de 0,1% en poids d'oxyhalogénure de terre rare, voire moins de 0,05 % en poids d'oxyhalogénure de terre rare, voire moins de 0,02 % en poids d'oxyhalogénure de terre rare.

De préférence, les atomes de Ln dans le composé ne sont liés qu'à des atome de X ou des atomes d'oxygène ou des atomes de A. C'est en particulier le cas pour un complexe de formule LnX₃.(NH₄X)ₓ dans lequel les atomes de Ln ne sont liés qu'à des atomes de X. Ici, on considère qu'aucun atome appartenant à NH₄X n'est lié aux atomes de Ln.

De préférence, on introduit dans le mélange une quantité de NH₄X qui est au moins la somme des deux quantités suivantes :
- A) un nombre de mole de NH₄X égal à une fois et de préférence trois fois le nombre de mole de Ln non lié à de l'oxygène,
- B) un nombre de mole de NH₄X égal à trois fois et de préférence cinq fois le nombre de mole d'atomes d'oxygène lié à Ln.

Notamment, on peut introduire dans le mélange une quantité de NH₄X qui est au moins la somme des deux quantités suivantes :
- A) un nombre de mole de NH₄X égal à trois fois le nombre de mole de Ln non lié à de l'oxygène,
- B) un nombre de mole de NH₄X égal à cinq fois le nombre de mole d'atomes d'oxygène lié à Ln.

Il est bien entendu que si du NH₄X est compté dans le cadre du calcul du A), le même NH₄X ne doit pas être pris en compte dans le cadre du calcul du B), et vice versa. Si le mélange ne contient pas d'oxygène lié à Ln, la quantité de NH₄X pour le B) seul est nulle.

Dans le cadre de la présente demande, on considère que le nombre de moles d'atomes d'oxygène lié à Ln est identique au nombre de moles d'oxyhalogénure de formule LnOX tel qu'obtenu par la méthode de dissolution décrite par la suite. A partir de la masse d'oxyhalogénure obtenue par la méthode de dissolution, on peut donc aisément calculer le nombre de mole d'atomes d'oxygène lié à Ln, en considérant que l'oxyhalogénure a pour formule LnOX. En cas de la présence de A (généralement Rb ou Cs), compte tenu de ce que cet atome a une très faible tendance à se combiner avec l'oxygène, sa présence n'intervient pas pour les calculs des quantités de NH₄X.

Il est bien entendu que pour calculer cette quantité, il convient de prendre en compte toutes les molécules de NH₄X présentes dans le mélange, que cet NH₄X soit complexé ou non, par exemple avec un halogénure de terre rare.

Le mélange peut comprendre un complexe du composé comprenant au moins une liaison Ln-X et de NH₄X. Ce complexe peut par exemple être préparé par chimie humide sur le principe suivant :
*on dissout tout d'abord un sel de terre rare comme un oxyde de terre rare ou un halogénure hydraté de terre rare dans l'hydracide correspondant (c'est-à-dire HCl si on souhaite obtenir un chlorure, HBr si on souhaite obtenir un bromure). A ce stade, on ajoute du AX (A étant en général Rb ou Cs) si l'on vise un halogénure contenant A. On ajoute à la solution de l'halogénure d'ammonium, de préférence 1 à 4 moles d'halogénure d'ammonium par mole d'halogénure de terre rare, de façon à obtenir une solution. Si l'on désire obtenir finalement un halogénure de terre rare Ln dopé par une autre terre rare Ln' (en fait par un halogénure de Ln') comme le Cerium, il suffit d'introduire lors de la dissolution dans l'hydracide le taux de Ln' souhaité (par exemple : 10% de CeX₃(H₂O)₇ dans une solution obtenu à partir de LaX₃(H₂O)₇ si l'on souhaite finalement obtenir LnX₃ anhydre dopé par 10% de CeX₃).*
*La solution est ensuite séchée en étuve ou par tout moyen approprié. Le sel obtenu, de formule LnX₃. (NH₄X)ₓ avec x = 3,5 est stable et peut être stocké en bidons étanches.*

Le mélange d'une part d'au moins un composé comprenant au moins une liaison Ln-X et d'autre part de NH₄X fait ensuite l'objet d'un traitement thermique. Pour ce traitement thermique, le mélange est généralement chargé dans un creuset, lequel peut être en platine, en carbone comme en graphite ou en molybdène ou en tantale ou en nitrure de bore ou en silice. Le creuset peut également être en graphite revêtu de carbone pyrolytique ou en graphite revêtu de carbure de silicium ou en graphite revêtu de nitrure de bore. De préférence, pour la fusion, on utilise un creuset permettant un démoulage du bloc à froid. Pour la réalisation des blocs selon l'invention, on utilise de préférence un creuset réalisé dans un matériau comprenant au moins 20 % en poids de carbone. Un tel matériau peut par exemple être en carbone ou en graphite, ou en carbone amorphe (ou carbone vitreux), ou en graphite revêtu de carbone pyrolytique (carbone vitreux également), ou en graphite revêtu de carbure de silicium, ou en graphite revêtu de nitrure de bore (pouvant être pyrolytique). Le creuset peut donc être revêtu d'une couche de carbone pyrolytique. Le matériau peut comprendre d'une part un substrat en graphite et d'autre part un revêtement, ce revêtement pouvant être en carbone pyrolytique ou en carbure de silicium ou en nitrure de bore (pouvant être pyrolytique). Le revêtement sert notamment à boucher la porosité du graphite.

Le creuset est ensuite positionné dans un four étanche dont l'atmosphère est purgée pour la rendre inerte, par exemple purgé sous vide primaire puis balayé par un courant d'azote sec. La température du four est ensuite montée progressivement au moins jusqu'à 400°C. L'eau du complexe s'élimine puis NH₄X se sublime et se dépose sur les parties froides en aval du four. Il est important que le mélange soit protégé de l'air ambiant et soit bien sous atmosphère inerte, notamment à partir de 300°C et de préférence à partir de 200°C. C'est pourquoi les entrées d'air potentielles dans l'installation se trouvent au delà de l'endroit ou se dépose le NH₄X de sorte que l'air ne puisse pas remonter jusqu'au mélange à purifier.

Compte tenu du fait que du NH₄X est généralement présent en excès dans le mélange, la température réelle du mélange montre généralement un palier correspondant à la température d'élimination du NH₄X, et ce même si la température de consigne est constamment croissante. Dans le cas du NH₄Cl, ce palier se situe entre 300 et 400°C. Ceci vaut non seulement si le NH₄X est au départ sous forme libre mais également s'il est sous forme complexé. Compte tenu de ce que la masse chauffée contient beaucoup moins de NH₄X après ce palier, on aurait pu s'attendre à ce que le mélange soit ensuite facilement oxydé à partir des impuretés présentes dans l'environnement gazeux (présence d'eau et d'oxygène), et ce d'autant plus que les températures sont plus élevées (à ce stade, la température de la masse chauffée est généralement supérieure à 300°C). La demanderesse a découvert que cela n'était pas le cas et qu'il était possible de maitriser l'oxydation de l'halogénure de terre rare.

Après le palier de départ du NH₄X, la température doit ensuite être montée rapidement jusqu'à une température suffisante pour faire fondre l'halogénure de terre rare souhaité (par exemple 880°C pour LaC1₃). Après le palier de départ du NH₄X, généralement entre 300 et 400°C, le mélange déjà transformé par rapport à l'origine (puisqu'il a perdu du NH₄X) peut être chauffé avec une vitesse supérieure à 50 °C/heure et même supérieure à 100 °C/heure et même supérieure à 150 °C/heure et même supérieure à 200 °C/heure. Généralement, la vitesse de chauffage est inférieure à 600 °C/heure compte tenu de ce qu'il convient généralement de ménager les matériaux de l'installation en fonction de leur résistance aux choc thermiques. Lorsque la matière chauffée est fondue, on préfère garder une température supérieure à la température de fusion pendant au moins une heure, généralement entre une et six heures.

Pour le chauffage du mélange, une fois que le mélange est à une température supérieure à 300 °C, on ne fait pas revenir sa température à la température ambiante ni même à une température inférieure à 200°C avant d'avoir atteint la fusion de l'halogénure de terre rare souhaité. Il est préférable de chauffer le mélange jusqu'à la fusion dans une seule étape de chauffe, sans baisser la température même momentanément avant l'obtention de la masse fondue comprenant l'halogénure fondu. L'ensemble de l'étape de chauffe (de la température ambiante jusqu'à la fusion) peut généralement être réalisée en moins de 10 heures, voire moins de 6 heures, voire moins de 4 heures.

La masse fondue peut ensuite être refroidie rapidement. On récupère ainsi un bloc d'halogénure de terre rare anhydre, comprenant moins de 0,1 % en poids d'eau et moins de 0,2 % en poids d'oxyhalogénure de terre rare, voire moins de 0,1 % en poids d'oxyhalogénure de terre rare, voire moins de 0,05 % en poids d'oxyhalogénure de terre rare, voire moins de 0,02% en poids d'oxyhalogénure de terre rare. Ce bloc est aisé à manipuler et à stocker. Généralement, on peut réaliser des blocs d'au moins 1 g par unité voire d'au moins 10 g par unité, voire d'au moins 50 g par unité, voire d'au moins 500 g par unité. Ces blocs présentent généralement une densité apparente d'au moins 75 %, voire d'au moins 80%, voire d'au moins 85 % de la densité théorique, étant entendu que la densité théorique est celle correspondant au même matériau exempt de porosité. Le bloc selon l'invention est polycristallin et contient une multitude de grains qui sont chacun de petits monocristaux. Un bloc contient généralement au moins 100 grains et même au moins 1000 grains. Aucun grain du bloc ne représente plus de 10% de la masse du bloc entier.

L'halogénure d'ammonium condensé sur les parties froides en aval du four peut au moins en partie être réutilisé, par exemple dans le procédé selon l'invention.

Pour mesurer le taux d'oxyhalogénure dans un halogénure de terre rare, il suffit de les séparer par l'eau (par exemple à la température ambiante) puisque les oxyhalogénures sont insolubles dans l'eau alors que les halogénures le sont. Les oxyhalogénures peuvent être récupéré par filtration par exemple sur un filtre en polypropylène (PP), puis séchés à 120 °C. Pour le cas ou l'halogénure comprend A (généralement Rb ou Cs), cette méthode conduit à la dissolution de AX puisque A ne forme pas d'oxyhalogénure. Cette méthode dite « méthode de dissolution » ou « méthode des insolubles » conduit bien, même en présence de A dans l'halogénure, à la détermination du taux d'oxyhalogénure de formule LnXO.

Le bloc selon l'invention peut être utilisé selon la revendication 29 comme matière première servant à la croissance de cristaux (généralement monocristaux) selon les techniques connus comme les croissances dites Bridgman, ou Kyropoulos ou Czochralski ou la croissance par la méthode de déplacement du gradient (« gradient freeze method » en anglais). Ces monocristaux selon la revendication 31 sont très purs et peuvent servir de matériau scintillateur. Cette préparation de cristaux est réalisée sous atmosphère neutre (azote ou argon par exemple) mais cette atmosphère peut même contenir de relativement fortes teneurs en eau et oxygène, c'est-à-dire de sorte que la somme des masses d'eau et d'oxygène dans l'atmosphère gazeuse soit inférieure à 200 ppm en poids. Généralement, pendant la réalisation du cristal (généralement monocristal), la teneur de l'atmosphère inerte en eau va de 10 à 180 ppm en poids et la teneur de l'atmosphère en oxygène va de 0,5 à 2 ppm en poids.

Du fait de la faible surface du ou des bloc(s) utilisé comme matière première et du fait également que cette surface n'augmente pas pendant la montée en température jusqu'à la fusion, le monocristal final est très pur et présente un rendement de scintillation remarquable. Ainsi, l'invention concerne également un monocristal de formule AₑLn_{f}X_{(3f+e)} dont les symboles ont les significations déjà données, ledit monocristal comprenant moins de 0,2% et même moins de 0,1%, voire moins de 0,05%, voire moins de 0,02% en poids d'oxyhalogénure de terre rare. Ceci vaut notamment lorsque Ln est choisi parmi La, Gd, Y, Lu et Ce, et lorsque X est choisi parmi Cl et Br. On peut plus particulièrement faire référence aux monocristaux suivants :
- ceux de composition générale Ln₁₋ₓCeₓBr₃, dans laquelle Ln est choisi parmi les lanthanides ou les mélanges de lanthanides du groupe : La, Gd, Y, Lu notamment choisi parmi les lanthanides ou les mélanges de lanthanides du groupe : La, Gd, et dans laquelle x est le taux molaire de substitution de Ln par du cérium, avec x supérieur ou égal à 0,01 mole % et strictement inférieur à 100 moles %,
- de composition générale Ln₁₋ₓCeₓCl₃, dans laquelle Ln est choisi parmi les lanthanides ou les mélanges de lanthanides du groupe : Y, La, Gd, Lu, notamment parmi les éléments ou les mélanges d'éléments du groupe : La, Gd, Lu, et dans laquelle x est le taux molaire de substitution de Ln par du cérium, avec x supérieur ou égal à 1 mole % et strictement inférieur à 100 moles %.

Les procédés de croissance précités peuvent mener à un monocristal de grande dimension, c'est-à-dire d'au moins 1 cm³, voire d'au moins 10 cm³ et même d'au moins 200 cm³. Ce monocristal peut ensuite être découpé aux tailles adaptées aux applications souhaitées.

Le monocristal selon l'invention, du fait de sa grande pureté présente un rendement lumineux particulièrement important. Ce rendement lumineux peut notamment être mesuré relativement à celui d'un cristal de Nal dopé par 600 ppm en poids d'iodure de TI dont la résolution en énergie à 622 KeV est de 6,8%, le temps d'intégration étant de 1 µs et la source radioactive étant le Cs 137 à 622 KeV. Le couplage entre les cristaux (Nal ou halogénure de terre rare) et le photomultiplicateur s'effectue au moyen d'une graisse silicone transparente jusqu' à 320 nm. Bien entendue, la face de sortie du Nal vers le photomultiplicateur est polie. Dans ces conditions de mesure, l'invention permet l'obtention de rendements lumineux d'au moins 90 % de celle du cristal de Nal dopé TI, en tout état de cause supérieurs à ce que l'on obtient sur des cristaux qui ne sont pas selon l'invention.

Le cristal ou monocristal peut notamment être réalisé dans un creuset en platine ou en graphite ou en graphite revêtu de carbone pyrolytique.

Dans les exemples qui suivent, on a mesuré la résolution en énergie de la façon suivante : on découpe dans le monocristal une pièce de 10x10x5 mm. Toutes les faces de la pièce sauf une des grandes faces 10*10 mm sont laissées brutes de découpe et la face sur laquelle on couple le photomultiplicateur (PMT) est polie. Le cristal est enveloppé dans plusieurs épaisseurs de ruban de PTFE (Téflon) sauf sur la face qui est couplée au PMT. La préparation du cristal est effectuée dans une boite à gants dont le point de rosée est inférieur à - 40°C.

### Exemple 1 : LaCl₃ anhydre

On attaque 433g de La₂O₃ par 1380 ml de HCl à 37% dilué dans 2450 ml d'eau. On ajoute 497g de NH₄Cl. On évapore ensuite l'eau et l'HCl en excès par chauffage à 100°C pour obtenir un complexe LaCl₃.(NH₄Cl)_{3,5}, lequel contient 0,7% en poids d'eau par mesure au Karl Fischer. Le complexe LaCl₃.(NH₄Cl)_{3,5} est bien un composé comprenant au moins une liaison Ln-X puisqu'il contient des liaisons La-Cl. Il est également à lui seul un mélange au sens de l'invention, comprenant d'une part un composé à liaison Ln-X et d'autre part NH₄X (en l'occurence NH₄Cl). Par ailleurs, au sein de ce mélange, la quantité de NH₄X est telle que le rapport du nombre de moles de NH₄X sur le nombre de moles de Ln non lié à de l'oxygène est de 3,5, ce qui correspond bien à un rapport préféré selon l'invention. Par ailleurs, on n'a pas à compter de NH₄X à introduire au titre de l'oxygène lié à Ln puisque le mélange de départ ne contient pas ce type de liaison.

Par chauffage avec une vitesse de 200°C/heure à partir de la température ambiante et jusqu'à 950°C, 200g du complexe sont ensuite décomposés avec sublimation de NH₄Cl et fondus dans un creuset en graphite revêtu de carbone pyrolytique, ledit creuset étant lui-même placé dans un tube en silice étanche sous balayage d'azote. L'atmosphère d'azote contenait environ 50 ppm en poids d'eau et entre 1 et 2 ppm en poids d'oxygène. La teneur en oxychlorure dans le bloc final, mesurée par dissolution, est de 0,01% en poids. La teneur en eau est inférieure à 0,1% en poids (limite de détection de la méthode utilisée). Le bloc obtenu a une masse de 651 g

### Exemple 2 (comparatif): LaCl₃ anhydre

On procède exactement comme pour l'exemple 1 sauf que l'on remplace le complexe par une poudre de LaCl₃ anhydre dont la teneur en oxychlorure est inférieure à 0,02 %, la taille de particules submillimétrique et la teneur en eau est non détectable au Karl Fischer.

La teneur en oxychlorure dans le bloc final, mesurée par dissolution, est de 0,23% en poids. La teneur en eau est inférieure à 0, 1 % en poids.

### Exemple 3 : LaBr₃ :Ce anhydre

On attaque 300 g de La₂O₃ par 630 ml de HBr à 47% dilué dans 2330 ml d'eau. On ajoute 682 g de NH₄Br. On filtre sur PP la solution obtenue. La solution est ensuite séchée à l'évaporateur rotatif dans un ballon de 10 l. Le complexe obtenu, de formule LaBr₃.(NH₄Br)_{3,5}, contient 0,23% en poids d'eau par mesure au Karl Fischer. On prélève ensuite 142,6g de ce complexe qu'on dope avec 0,5% en poids de (NH₄Br)_{3,5} CeBr₃ et qu'on chauffe à 200°C/h sous balayage d'azote dans un creuset en graphite. On fait un palier de 4h30 à 860°C. L'atmosphère d'azote contenait environ 50 ppm en poids d'eau et entre 1 et 2 ppm en poids d'oxygène. Le culot fondu pèse 76,61g et contient 0,035% seulement d'oxybromure LaOBr (mesuré par la méthode des insolubles). La teneur en eau est de plus inférieure à 0,1% en poids.

La densité hydrostatique de ce bloc, mesuré par plongée dans l'hexane est de 4,92 g/cm³ environ, soit 87% de la densité théorique, ce qui prouve une bonne densification.

Ce bloc fondu est ensuite utilisé pour une croissance en four Bridgman en creuset graphite sous un balayage d'azote. L'atmosphère d'azote contenait environ 50 ppm en poids d'eau et entre 1 et 2 ppm en poids d'oxygène. Le Cristal obtenu est clair et exempt d'inclusions blanches d'oxybromures et de bulles. La teneur en oxybromure de ce cristal est de 0,05 % en poids. Plus de 80% de la masse de ce cristal est propre à une utilisation en tant que scintillateur.

### Exemple 4 : LaBr₃ anhydre à partir de complexe humide

On utilise le complexe LaBr₃.(NH₄Br)_{3,5} comme préparé dans l'exemple précédent mais en l'humidifiant de façon à ce qu'il contienne 14,7% en poids d'eau par mesure au Karl Fischer. On prélève ensuite 124 g de ce mélange (complexe + eau) que l'on chauffe à 200°C/h sous balayage d'azote dans un creuset en graphite, jusqu'à 860°C. On fait un palier de 4h30 à 860°C. L'atmosphère d'azote contenait environ 50 ppm en poids d'eau et entre 1 et 2 ppm en poids d'oxygène. Le culot fondu pèse 64,1 g et contient 0,034% en poids seulement d'oxybromure (mesuré par la méthode des insolubles). La teneur en eau est inférieure à 0, 1 % en poids.

### Exemple 6 : GdBr₃ anhydre

On attaque 271,2 g de Gd₂O₃ par 796 g de HBr à 48% dilué dans 430 g d'eau. On ajoute ensuite 661,2 g de NH₄Br et 855g d'eau. On filtre sur PP la solution obtenue. La solution est ensuite séchée à l'évaporateur rotatif dans un ballon de 10 I. On obtient alors 1164 g de complexe (NH₄Br)_{4,5}GdBr₃. Le complexe obtenu contient 6,3 % d'eau par mesure au Karl Fischer. On prélève ensuite 254,7g de ce complexe qu'on chauffe à 200°C/h sous balayage d'azote dans un creuset en graphite. On fait un palier de 1h30 à 815°C. L'atmosphère d'azote contenait environ 50 ppm en poids d'eau et entre 1 et 2 ppm en poids d'oxygène. Le culot fritté mais non fondu pèse 104,9g. C'est donc un solide pulvérulent que l'on ramène dans les conditions ambiantes. On recharge le four avec 92,7g du culot fritté précédent qu'on chauffe à 200°C/h sous balayage d'azote dans un creuset en graphite. On fait un palier de 1 h30 à 840°C. L'atmosphère d'azote contenait environ 50 ppm en poids d'eau et entre 1 et 2 ppm en poids d'oxygène. Le culot fondu pèse 92,7g et contient 0,65 % en poids de GdOBr (mesuré par la méthode des insolubles), ce qui démontre que le fait de ramener le bloc a température ambiante avant fusion est contre-indiqué.

### Exemple 7 : GdBr₃ anhydre

On utilise pour cet essai le complexe (NH₄Br)_{4,5} GdBr₃ comme préparé selon l'exemple précédent. Le complexe obtenu contient 6,3 % en poids d'eau par mesure au Karl Fischer. On prélève ensuite 245,7g de ce complexe que l'on chauffe à 200°C/h sous balayage d'azote dans un creuset en graphite jusqu'à 840°C. On fait un palier de 1 h30 à 840°C. L'atmosphère d'azote contenait environ 50 ppm en poids d'eau et entre 1 et 2 ppm en poids d'oxygène. Le culot fondu pèse 105,3g et contient 0,038% en poids seulement d'oxybromure GdOBr (mesuré par la méthode des insolubles). Ce résultat est d'autant plus exemplaire que le gadolinium est une terre rare lourde (dite yttrique) dont les bromures sont très sensibles à l'hydratation.

### Exemple 8 (comparatif) : Monocristal à partir de poudre de LaCl₃

On utilise le même lot de poudre de LaCl₃ anhydre que celui utilisé pour l'exemple 2 pour une croissance en four Bridgman en creuset graphite sous un balayage d'azote. L'atmosphère d'azote contenait environ 50 ppm en poids d'eau et entre 1 et 2 ppm en poids d'oxygène. Le Cristal obtenu présente de nombreuses inclusions blanches d'oxychlorures et bulles organisées en filaments le long de l'axe de tirage. La teneur de ce cristal en oxychlorure est de 0,25 % en poids. Environ 90% de la masse de ce cristal est impropre à une utilisation en tant que scintillateur.

### Exemple 9 : RbGd₂Cl₇ anhydre

On attaque 138,2 g de Rb₂CO₃ par 242 g de HCl à 37% dilué dans 165g d'eau. On filtre sur PP la solution obtenue. On attaque ensuite 433,8 g de Gd₂O₃ par 750 g de HCl à 37% dilué dans 482 g d'eau. Après dissolution totale, on ajoute la solution filtrée de Rubidium. On ajoute enfin 576,2 g de NH₄Cl et 881g d'eau. On filtre sur PP la solution obtenue. Le pH est de - 0.32 et la densité de la solution est de 1,24. La solution est ensuite séchée à l'évaporateur rotatif dans un ballon de 10 l. On obtient alors 1227 g de (NH₄Cl)₉RbGd₂Cl₇. On prélève ensuite 142,6g de ce complexe que l'on chauffe à 200°C/h sous balayage d'azote dans un creuset en graphite jusqu'à 660°C. On fait un palier de 4h30 à 660°C. L'atmosphère d'azote contenait environ 50 ppm en poids d'eau et entre 1 et 2 ppm en poids d'oxygène. Le culot fondu contient moins de 0,05% en poids seulement de GdOCl (mesuré par la méthode des insolubles).

### Exemple 10: Synthèse à partir de LaOBr

On réalise le mélange suivant dans un creuset en carbone vitreux : 0,5874 g de LaOBr, 1,3585g de NH₄Br (soit 5,5 moles) et 10,0678g de complexe (NH₄Br)_{3,5}LaBr₃. On chauffe le mélange avec une vitesse de 200°C/h jusqu'à 830°C avec un palier de 2h à cette température. L'atmosphère d'azote contenait environ 50 ppm en poids d'eau et entre 1 et 2 ppm en poids d'oxygène. Le taux d'insoluble dans le bloc final est de 0,19% en poids.

### Exemple 11 : Monocristal de LaCl₃

On utilise un bloc de 1kg de LaCl₃ à 10% en poids de CeCl₃, fabriqué selon l'invention et dont la teneur en LaOCl est inférieure à 0,05% en poids. Ce bloc est ensuite utilisé pour une croissance du type Bridgman en creuset graphite. L'atmosphère d'azote contenait environ 50 ppm en poids d'eau et entre 1 et 2 ppm en poids d'oxygène. Le cristal obtenu est très clair. Sa teneur en oxychlorure par la méthode des insolubles est inférieure à 0,05%. On découpe ensuite dans ce cristal une pièce de 10x10x5 mm dont l'on compare le rendement de scintillation à une pièce de Nal:TI (Nal dopé avec 600 ppm en poids d'iodure de TI) selon le protocole suivant:

| | |
|---|---|
| Photomultiplicateur: | Hamamatsu R-1306 |
| Référence: | Cristal de Nal de 50mm de diametre et 50 mm de longueur |
| Temps d'intégration: | 1 µs |
| Source radioactive: | Cs 137 à 622 KeV |

L'émission lumineuse du cristal de LaCl₃ est de 93% de celle du cristal de Nal de référence. Sa résolution en énergie est de 3,6%. La composante principale du temps de décroissance de la scintillation est de 27 nanosecondes.

### Exemple 12 (comparatif) : Monocristal de LaCl₃:

On utilise 1 kg de poudres de LaCl₃ et de CeCl₃ commerciales (teneur en LaOX et eau de l'exemple 2). La masse de CeCl₃ représente 10% de la masse du mélange de ces deux poudres. On les fait fondre dans un creuset graphite et on fait une croissance de type Kyropoulos (KC 01). L'atmosphère d'azote contenait environ 50 ppm en poids d'eau et entre 1 et 2 ppm en poids d'oxygène. Le cristal obtenu est légérement laiteux. Sa teneur en insolubles est de 0,1% en poids. On découpe ensuite dans ce cristal une pièce de 10x10x5 mm dont l'on compare le rendement de scintillation à une pièce de Nal:Tl selon le même protocole que pour l'exemple précédent. L'émission lumineuse du cristal de LaCl₃ est de 83% de celle du cristal de Nal de référence. Sa résolution en Energie est de 3,9%.

### Exemple 13 (comparatif): Monocristal de LaCl₃ :

On réalise un cristal par croissance du type Bridgman en creuset silice conformément à l'enseignement de la Publication IEEE transaction on Nuclear science: "Scintillation properties of LaCl₃ crystals: Fast, efficient and High Energy resolution scintillators". La masse de CeCl₃ représente 10% de la masse du mélange avant croissance du cristal. On découpe ensuite dans ce cristal une pièce de 10x10x5 mm dont l'on compare le rendement de scintillation à une pièce de Nal:Tl selon le même protocole que pour les deux exemples précédents. L'émission lumineuse du cristal de LaCl₃ est de 87% de celle du cristal de Nal de référence. Sa résolution en Energie est de 4,2%.

### Exemple 14: Monocristal de LaBr3:

On utilise trois blocs de LaBr₃ dopés par 0,5% en poids de CeBr₃ de 1kg chacun fabriqués selon l'invention et tel que la teneur en LaOBr soit < 0.05% en poids. Ce bloc est ensuite utilisé pour une croissance du type Czochralski en creuset graphite. L'atmosphère d'azote contenait environ 50 ppm en poids d'eau et entre 1 et 2 ppm en poids d'oxygène. Le cristal obtenu est très clair. La teneur en oxychlorure de ce bloc n'est pas mesurable par la méthode des insolubles. On découpe ensuite dans ce cristal une pièce de 10x10x5 mm dont l'on compare le rendement de scintillation à une pièce de Nal:TI selon le protocole suivant:
- Photomultiplicateur: Hamamatsu R-1306
- Référence: Cristal de Nal:Tl (Nal dopé par 600 ppm en poids de iodure de TI) de 50mm de diametre et 50 mm de longueur.
- La résolution en énergie de ce cristal de référence est de 6,8% sur la raie du Cs137.
- les cristaux mesurés sont enveloppés dans du Téflon et couplés au photomultiplicateur (PMT) en utilisant une huile silicone (EDM fluid 200)
- Intégration time: 1 µs
- Source radioactive: Cs 137 à 622 KeV

L'émission lumineuse du cristal de LaBr₃ est de 147% de celle du cristal de Nal de référence. Sa résolution en énergie est de 4,2%. La composante principale du temps de décroissance de la scintillation est de 39 nanosecondes.

### Exemple 15 (comparatif): Monocristal de LaBr₃:

Un cristal obtenu par croissance du type Bridgman en creuset silice selon les enseignements de la Publication "Applied physics Letters du 03 Sept 2001 (Vol 79 N°10) est comparé aux essais précédents. Ce cristal contient également 0,5% en poids de CeBr₃. On découpe ensuite dans ce cristal une pièce de 10x10x5 mm dont l'on compare le rendement de scintillation à une pièce de Nal:Tl selon le même protocole que pour l'exemple précédent. Le cristal est légèrement laiteux.

L'émission lumineuse du cristal de LaBr₃ est de 102% de celle du cristal de Nal de référence. La composante principale du temps de décroissance de la scintillation est de 38 nanosecondes.

### Exemple 16 : Monocristal de LaCl3:

On utilise trois blocs de LaCl₃ dopés par 5% en poids de CeCl₃ de 1 kg chacun fabriqués selon l'invention et tel que la teneur en LaOCl soit < 0,05% en poids. Ce bloc est ensuite utilisé pour une croissance du type Bridgman en creuset graphite. L'atmosphère d'azote contenait environ 50 ppm en poids d'eau et entre 1 et 2 ppm en poids d'oxygène. Le cristal obtenu est très clair. La teneur en oxychlorure de ce bloc n'est pas mesurable par la méthode des insolubles. Elle est inférieure à 0,05 % en poids. On découpe ensuite dans ce cristal une pièce de 10x10x5 mm dont l'on compare le rendement de scintillation à une pièce de Nal:TI selon le protocole suivant:
- Photomultiplicateur: Hamamatsu R-1306
- Référence: Cristal de Nal:Tl (Nal dopé par 600 ppm en poids d'iodure deTI) de 50mm de diametre et 50 mm de long.
- la résolution en énergie de ce cristal de référence est de 6.8% sur la raie du Cs137.
- les cristaux mesurés sont enveloppés dans du Téflon et couplés au photomultiplicateur (PMT) en utilisant une huile silicone (EDM fluid 200)
- Intégration time: 1 µs
- Source radioactive: Cs 137 à 622 KeV

L'émission lumineuse du cristal de LaCl₃ est de 98% de celle du cristal de Nal de référence. Sa résolution en énergie est de 4,6%. La composante principale du temps de décroissance de la scintillation est de 28 nanosecondes.

### Exemple 17 : LaCl₃ anhydre

On procède comme pour l'exemple 1 sauf que le bloc est préparé dans un creuset en platine. Le bloc final colle au creuset et est beaucoup plus difficile à démouler que dans le cas du creuset en graphite revêtu de carbone pyrolytique.

## Revendications

1. Procédé de préparation d'un bloc polycristallin d'au moins 10 g d'halogénure de formule AₑLn_{f}X_{(3f+e)} dans laquelle Ln représente une ou plusieurs terre rare(s), X représente un ou plusieur(s) atome(s) d'halogène choisi parmi Cl, Br ou I, et A représente un ou plusieurs alcalin(s) comme K, Li, Na, Rb ou Cs, e pouvant être nul, étant inférieur où égal à 3f, et f étant supérieur ou égal à 1, ledit bloc comprenant moins de 0,1 % en poids d'eau et moins de 0,2 % en poids d'oxyhalogénure de terre rare, comprenant une étape de chauffage d'un mélange d'une part d'au moins un composé comprenant au moins une liaison Ln-X et d'autre part d'une quantité suffisante de NH₄X pour l'obtention du taux souhaité d'oxyhalogénure, ledit composé et NH₄X pouvant être combinés au moins partiellement au sein d'un complexe, ladite étape menant à une masse fondue comprenant l'halogénure de terre rare de formule AₑLn_{f}X_{(3f+e)}, ladite étape de chauffage étant suivie d'une étape de refroidissement après l'obtention de la masse fondue, ladite étape de chauffage, après avoir atteint 300°C ne redescendant jamais en dessous de 200°C avant l'obtention de ladite masse fondue.

2. Procédé selon la revendication précédente, **caractérisé en ce que** le composé comprenant au moins une liaison Ln-X est de formule AᵣLnₛOᵤXᵣ₊₃ₛ₋₂ᵤ dans laquelle A, X et Ln ont la signification déjà donnée, r,s et u représentant des valeurs entières ou non entières vérifiant les conditions suivantes de façon cumulative :
r pouvant aller de 0 à 2s,
s étant supérieur ou égal à 1,
u pouvant aller de 0 à s,
ce composé pouvant être complexé ou non complexé avec de l'eau ou du NH₄X.

3. Procédé selon l'une des revendications précédentes, **caractérisé en ce que** les atomes de Ln du composé ne sont liés qu'à des atomes de X ou d'oxygène ou de A.

4. Procédé selon la revendication précédente, **caractérisé en ce que** l'étape de chauffage est réalisée sans baisser la température avant l'obtention de la masse fondue.

5. Procédé selon l'une des revendications précédentes, **caractérisé en ce que** l'étape de chauffage comprend un palier de température dû à l'élimination de NH₄X en phase gazeuse.

6. Procédé selon la revendication précédente, **caractérisé en ce que** l'étape de chauffage est réalisée avec une vitesse de montée en température supérieure à 50°C/heure après ledit palier de température.

7. Procédé selon la revendication précédente, **caractérisé en ce que** l'étape de chauffage est réalisée avec une vitesse de montée en température supérieure à 100°C/heure après ledit palier de température.

8. Procédé selon la revendication précédente, **caractérisé en ce que** l'étape de chauffage est réalisée avec une vitesse supérieure à 150°C/heure après ledit palier de température.

9. Procédé selon l'une des revendications précédentes **caractérisé en ce que** l'étape de chauffage dure moins de 10 heures.

10. Procédé selon la revendication précédente **caractérisé en ce que** l'étape de chauffage dure moins de 6 heures.

11. Procédé selon la revendication précédente **caractérisé en ce que** l'étape de chauffage dure moins de 4 heures.

12. Procédé selon l'une des revendications précédentes, **caractérisé en ce que** l'étape de chauffage est réalisée dans une atmosphère de gaz inerte dont les teneurs en eau et en oxygène sont telles que la somme des masses d'eau et d'oxygène dans l'atmosphère gazeuse soit inférieure à 200 ppm en poids.

13. Procédé selon la revendication précédente **caractérisé en ce que** la teneur de l'atmosphère inerte en eau va de 10 à 180 ppm en poids et la teneur de l'atmosphère en oxygène va de 0,5 à 2 ppm en poids.

14. Procédé selon l'une des revendications précédentes, **caractérisé en ce que** la quantité de NH₄X est d'au moins la somme des deux quantités suivantes :
- A) un nombre de mole de NH₄X égal à une fois le nombre de mole de Ln non lié à de l'oxygène,
- B) un nombre de mole de NH₄X égal à trois fois le nombre de mole d'atomes d'oxygène lié à Ln.

15. Procédé selon la revendication précédente, **caractérisé en ce que** la quantité de NH₄X est d'au moins la somme des deux quantités suivantes :
- A) un nombre de mole de NH₄X égal à trois fois le nombre de mole de Ln non lié à de l'oxygène,
- B) un nombre de mole de NH₄X égal à cinq fois le nombre de mole d'atomes d'oxygène lié à Ln.

16. Procédé selon l'une des revendications précédentes **caractérisé en ce que** l'étape de chauffage est réalisée dans un creuset constitué d'un matériau comprenant au moins 20 % en poids de carbone.

17. Procédé selon la revendication précédente **caractérisé en ce que** le creuset est en carbone ou en carbone vitreux ou en graphite.

18. Procédé selon l'une des deux revendications précédentes **caractérisé en ce que** le creuset est revêtu d'une couche de carbone pyrolytique.

19. Bloc polycristallin d'au moins 1 g d'halogénure de formule AₑLn_{f}X_{(3f+e)} dans laquelle Ln représente une ou plusieurs terre rare(s), X représente un ou plusieur(s) atome(s) d'halogène choisi parmi Cl, Br ou I, et A représente un ou plusieurs alcalin(s) comme K, Li, Na, Rb ou Cs, e et f représentant des valeurs telles que
- e, pouvant être nul, est inférieur où égal à 3f,
- f est supérieur ou égal à 1,
comprenant moins de 0,1 % en poids d'eau et moins de 0,2 % en poids d'oxyhalogénure de terre rare.

20. Bloc selon la revendication précédente, **caractérisé en ce qu'**il comprends moins de 0,1 % en poids d'oxyhalogénure de terre rare.

21. Bloc selon la revendication précédente, **caractérisé en ce qu'**il comprend moins de 0,05 % en poids d'oxyhalogénure de terre rare.

22. Bloc selon la revendication précédente, **caractérisé en ce qu'**il comprend moins de 0,02 % en poids d'oxyhalogénure de terre rare.

23. Bloc selon l'une des revendications de bloc précédentes **caractérisé en ce qu'**il pèse au moins 10 g.

24. Bloc selon la revendication précédente **caractérisé en ce qu'**il pèse au moins 50 g.

25. Bloc selon l'une des revendications de bloc précédentes **caractérisé en ce qu'**il présente une densité apparente d'au moins 75 % de la densité théorique correspondant au même matériau exempt de porosité.

26. Bloc selon l'une des revendications de bloc précédentes **caractérisé en ce que** Ln est La ou Ce et X est Cl ou Br.

27. Bloc selon l'une des revendications de bloc précédentes **caractérisé en ce qu'**aucun de ses grains ne représente plus de 10% de la masse du bloc entier.

28. Procédé selon l'une des revendications 1 à 18, **caractérisé en ce que** le bloc est l'un de ceux des revendications 19 à 27.

29. Utilisation d'au moins un bloc de l'une des revendications de bloc précédentes pour la préparation d'un cristal, comprenant la fusion dudit bloc.

30. Utilisation selon la revendication précédente, **caractérisé en ce que** le cristal est un monocristal.

31. Monocristal de formule AₑLn_{f}X_{(3f+e)} dans laquelle Ln représente une ou plusieurs terre rare(s), X représente un ou plusieur(s) atome(s) d'halogène choisi parmi Cl, Br ou I, et A représente un ou plusieurs alcalin(s) comme K, Li, Na, Rb ou Cs, e et f représentant des valeurs telles que
- e, pouvant être nul, est inférieur où égal à 3f,
- f est supérieur ou égal à 1,
comprenant moins de 0,1% en poids d'oxyhalogénure de terre rare.

32. Monocristal selon la revendication précédente **caractérisé en ce que** sa teneur en oxyhalogénure est inférieure à 0,05% en poids.

33. Monocristal selon la revendication précédente **caractérisé en ce que** sa teneur en oxyhalogénure est inférieure à 0,02% en poids.

34. Monocristal selon l'une des revendications de monocristal précédentes **caractérisé en ce que** Ln est choisi parmi La, Gd, Y, Lu et Ce, et X est choisi parmi Cl et Br.

35. Monocristal selon l'une des revendications de monocristal précédentes **caractérisé en ce que** son volume est d'au moins 10 cm³.

36. Monocristal selon l'une des revendications de monocristal précédentes **caractérisé en ce que** son rendement lumineux est d'au moins 90% de celui d'un cristal de Nal dopé par 600 ppm en poids d'iodure de TI dont la résolution en énergie à 622 KeV est de 6,8%, le temps d'intégration étant de 1 µs et la source radioactive étant le Cs 137 à 622 KeV.

37. Monocristal selon l'une des revendications de monocristal précédentes **caractérisé en ce que** sa résolution en énergie est inférieure à 5%.

38. Monocristal selon la revendication précédente **caractérisé en ce que** sa résolution en énergie est inférieure à 4%.

39. Monocristal selon la revendication précédente **caractérisé en ce que** sa résolution en énergie est inférieure à 3,5%.

40. Monocristal selon l'une des revendications de monocristal précédentes **caractérisé en ce que** le temps de décroissance de la composante principale est inférieur à 40 nanosecondes.

41. Monocristal selon la revendication précédente **caractérisé en ce que** le temps de décroissance de la composante principale est inférieur à 30 nanosecondes.

42. Monocristal selon la revendication précédente **caractérisé en ce que** le temps de décroissance de la composante principale est inférieur à 20 nanosecondes.

## Claims

1. A method of preparing a polycrystalline block of at least 10 g of a halide of formula AₑLn_{f}X_{(3f+e)} in which Ln represents one or more rare earths, X represents one or more halogen atoms chosen from Cl, Br or I, and A represents one or more alkali metals such as K, Li, Na, Rb or Cs, e, which may be zero, being less than or equal to 3f, and f being greater than or equal to 1, said block comprising less than 0.1% by weight of water and less than 0.2% by weight of a rare-earth oxyhalide, comprising a step of heating a mixture of, on the one hand, at least one compound having at least one Ln-X bond and, on the other hand, a sufficient amount of NH₄X in order to obtain the desired oxyhalide content, said compound and NH₄X possibly being combined, at least partially, within a complex, said step resulting in a molten mass comprising the rare-earth halide of formula AₑLn_{f}X_{(3f+e)}, said heating step being followed by a cooling step after the molten mass has been obtained, and said heating step, after having reached 300°C never going back down below 200°C before said molten mass has been obtained.

2. The method as claimed in the preceding claim, **characterized in that** the compound having at least one Ln-X bond is of formula AᵣLnₛOᵤXᵣ₊₃ₛ₋₂ᵤ in which A, X and Ln have the meanings given above, r,s and u representing integer or noninteger values that meet, cumulatively, the following conditions:
r ranging from 0 to 2s,
s being greater than or equal to 1,
u ranging from 0 to s,
which compound may or may not be complexed with water or with NH₄X.

3. The method as claimed in either of the preceding claims, **characterized in that** the Ln atoms of the compound are linked to X or oxygen or A atoms.

4. The method as claimed in the preceding claim, **characterized in that** the heating step is carried out without lowering the temperature before the molten mass is obtained.

5. The method as claimed in one of the preceding claims, **characterized in that** the heating step includes a temperature hold owing to the elimination of the NH₄X in gaseous phase.

6. The method as claimed in the preceding claim, **characterized in that** the heating step is carried out with a rate of temperature rise of greater than 50°C/hour after said temperature hold.

7. The method as claimed in the preceding claim, **characterized in that** the heating step is carried out with a rate of temperature rise of greater than 100°C/hour after said temperature hold.

8. The method as claimed in the preceding claim, **characterized in that** the heating step is carried out with a rate of temperature rise of greater than 150°C/hour after said temperature hold.

9. The method as claimed in one of the preceding claims, **characterized in that** the heating step lasts less than 10 hours.

10. The method as claimed in the preceding claim, **characterized in that** the heating step lasts less than 6 hours.

11. The method as claimed in the preceding claim, **characterized in that** the heating step lasts less than 4 hours.

12. The method as claimed in one of the preceding claims, **characterized in that** the heating step is carried out in an inert gas atmosphere, the water and oxygen contents of which are such that the sum of the water and oxygen masses in the gaseous atmosphere is less than 200 ppm by weight.

13. The method as claimed in the preceding claim, **characterized in that** the water content of the inert atmosphere ranges from 10 to 180 ppm by weight and the oxygen content of the atmosphere ranges from 0.5 to 2 ppm by weight.

14. The method as claimed in one of the preceding claims, **characterized in that** the amount of NH₄X is at least the sum of the following two quantities:
- A) a number of moles of NH₄X equal to one times the number of moles of Ln that are not linked to an oxygen;
- B) is a number of moles of NH₄X equal to three times the number of moles of oxygen atoms linked to Ln.

15. The method as claimed in the preceding claim, **characterized in that** the amount of NH₄X is at least the sum of the two following quantities:
- A) a number of moles of NH₄X equal to three times the number of moles of Ln that are not linked to an oxygen;
- B) a number of moles of NH₄X equal to five times the number of moles of oxygen atoms linked to Ln.

16. The method as claimed in one of the preceding claims, **characterized in that** the heating step is carried out in a crucible made of a material containing at least 20% carbon by weight.

17. The method as claimed in the preceding claim, **characterized in that** the crucible is made of carbon or glassy carbon or graphite.

18. The method as claimed in either of the preceding two claims, **characterized in that** the crucible is coated with a layer of pyrolytic carbon.

19. A polycrystalline block of at least 1 g of halide of formula AₑLn_{f}X_{(3f+e)} in which Ln represents one or more rare earths, X represents one or more halogen atoms chosen from Cl, Br or I, and A represents one or more alkali metals such as K, Li, Na, Rb or Cs, e and f representing values such that:
- e, which may be zero, is less than or equal to 3f;
- f is greater than or equal to 1;
comprising less than 0.1 % by weight of water and less than 0.2% by weight of rare-earth oxyhalide.

20. The block as claimed in the preceding claim, **characterized in that** it comprises less than 0.1% by weight of rare-earth oxyhalide.

21. The block as claimed in the preceding claim, **characterized in that** it comprises less than 0.05% by weight of rare-earth oxyhalide.

22. The block as claimed in the preceding claim, **characterized in that** it comprises less than 0.02% by weight of rare-earth oxyhalide.

23. The block as claimed in one of the preceding block claims, **characterized in that** it weighs at least 10 g.

24. The block as claimed in the preceding claim, **characterized in that** it weighs at least 50 g.

25. The block as claimed in one of the preceding block claims, **characterized in that** it has a bulk density of at least 75% of the theoretical density corresponding to the same material with no porosity.

26. The block as claimed in one of the preceding block claims, **characterized in that** Ln is La or Ce and X is Cl or Br.

27. The block as claimed in one of the preceding block claims, **characterized in that** none of its grains represents more than 10% of the mass of the entire block.

28. The method as claimed in one of claims 1 to 18, **characterized in that** the block is one of those of claims 19 to 27.

29. Use of at least one block of one of the preceding block claims for the preparation of a crystal, comprising the melting of said block.

30. Use according to preceding claim, **characterized in that** the crystal is a single crystal.

31. A single crystal of formula AₑLn_{f}X_{(3f+e)} in which Ln represents one or more rare earths, X represents one or more halogen atoms chosen from Cl, Br or I, and A represents one or more alkali metals such as K, Li, Na, Rb or Cs, e and f representing values such that:
- e, which may be zero, is less than or equal to 3f;
- f is greater than or equal to 1;
comprising less than 0.1 % by weight of rare-earth oxyhalide.

32. The single crystal as claimed in the preceding claim, **characterized in that** its oxyhalide content is less than 0.05% by weight.

33. The single crystal as claimed in the preceding claim, **characterized in that** its oxyhalide content is less than 0.02% by weight.

34. The single crystal as claimed in one of the preceding single-crystal claims, **characterized in that** Ln is chosen from La, Gd, Y, Lu and Ce, and X is chosen from Cl and Br.

35. The single crystal as claimed in one of the preceding single-crystal claims, **characterized in that** its volume is at least 10 cm³.

36. The single crystal as claimed in one of the preceding single-crystal claims, **characterized in that** its luminous efficiency is at least 90% of that of a Nal crystal doped with 600 ppm by weight of TI iodide, the energy resolution of which at 622 keV is 6.8%, the integration time being 1 µs and the radioactive source being ¹³⁷CS at 622 keV.

37. The single crystal as claimed in one of the preceding single-crystal claims, **characterized in that** its energy resolution is less than 5%.

38. The single crystal as claimed in the preceding claim, **characterized in that** its energy resolution is less than 4%.

39. The single crystal as claimed in the preceding claim, **characterized in that** its energy resolution is less than 3.5%.

40. The single crystal as claimed in one of the preceding single-crystal claims, **characterized in that** the time for the main component to decay is less than 40 nanoseconds.

41. The single crystal as claimed in the preceding claim, **characterized in that** the time for the main component to decay is less than 30 nanoseconds.

42. The single crystal as claimed in the preceding claim, **characterized in that** the time for the main component to decay is less than 20 nanoseconds.

## Patentansprüche

1. Verfahren zur Herstellung eines polykristallinen Blocks aus mindestens 10 g Halogenid mit der Formel AₑLn_{f}X_{(3f+e)}, in welcher Ln ein oder mehrere Seltenerdmetalle, X ein oder mehrere Halogenatome, die aus Cl, Br oder I ausgewählt sind, und A ein oder mehrere Alkalimetalle wie K, Li, Na, Rb oder Cs bedeutet, e Null sein kann und kleiner als oder gleich 3f ist und f größer als oder gleich 1 ist, wobei der Block weniger als 0,1 Gew.-% Wasser und weniger als 0,2 Gew.-% Seltenerdmetallhalogenidoxid enthält, welches eine Stufe des Erhitzens eines Gemischs aus einerseits mindestens einer Verbindung, die mindestens eine Ln-X-Bindung enthält, und andererseits einer NH₄X-Menge, die für das Erhalten des gewünschten Halogenidoxidanteils ausreicht, umfasst,
wobei diese Verbindung und NH₄X wenigstens teilweise in einem Komplex kombiniert sein können, die Stufe zu einer geschmolzenen Masse führt, die ein Seltenerdmetallhalogenid mit der Formel AₑLn_{f}X_{(3f+e)} umfasst, auf diese Erwärmungsstufe eine Abkühlstufe nach Erhalten der geschmolzenen Masse folgt und diese Erwärmungsstufe, nachdem 300 °C erreicht worden sind, niemals auf unter 200 °C vor Erhalten dieser geschmolzenen Masse zurückfällt.

2. Verfahren nach dem vorhergehenden Anspruch, **dadurch gekennzeichnet, dass** die Verbindung, die mindestens eine Ln-X-Bindung umfasst, die Formel AᵣLnₛOᵤXᵣ+3s-2u hat, in welcher A, X und Ln die bereits angegebene Bedeutung haben und r, s und u Werte bedeuten, die gegebenenfalls nicht ganzzahlig sind und folgende Bedingungen kumulativ erfüllen:
r kann 0 bis 2s betragen,
s beträgt mehr als oder gleich 1 und
u kann 0 bis s betragen,
wobei diese Verbindung gegebenenfalls mit Wasser oder NH₄X komplexiert sein kann.

3. Verfahren nach einem der vorhergehenden Ansprüche, **dadurch gekennzeichnet, dass** die Ln-Atome der Verbindung nur mit X- oder Sauerstoff- oder A-Atomen verbunden sind.

4. Verfahren nach dem vorhergehenden Anspruch, **dadurch gekennzeichnet, dass** die Erhitzungsstufe durchgeführt wird, ohne die Temperatur vor Erhalten der geschmolzenen Masse zu senken.

5. Verfahren nach einem der vorhergehenden Ansprüche, **dadurch gekennzeichnet, dass** die Erhitzungsstufe ein Auf-Temperatur-Halten umfasst, das auf die Entfernung des NH₄X in die Gasphase zurückzuführen ist.

6. Verfahren nach dem vorhergehenden Anspruch, **dadurch gekennzeichnet, dass** die Erhitzungsstufe mit einer Temperaturanstiegsgeschwindigkeit von über 50 °C/Stunde nach dem Auf-Temperatur-Halten durchgeführt wird.

7. Verfahren nach dem vorhergehenden Anspruch, **dadurch gekennzeichnet, dass** die Erhitzungsstufe mit einer Temperaturanstiegsgeschwindigkeit von über 100 °C/Stunde nach dem Auf-Temperatur-Halten durchgeführt wird.

8. Verfahren nach dem vorhergehenden Anspruch, **dadurch gekennzeichnet, dass** die Erhitzungsstufe mit einer Geschwindigkeit von über 150 °C/Stunde nach dem Auf-Temperatur-Halten durchgeführt wird.

9. Verfahren nach einem der vorhergehenden Ansprüche, **dadurch gekennzeichnet, dass** die Erhitzungsstufe weniger als 10 Stunden dauert.

10. Verfahren nach dem vorhergehenden Anspruch, **dadurch gekennzeichnet, dass** die Erhitzungsstufe weniger als 6 Stunden dauert.

11. Verfahren nach dem vorhergehenden Anspruch, **dadurch gekennzeichnet, dass** die Erhitzungsstufe weniger als 4 Stunden dauert.

12. Verfahren nach einem der vorhergehenden Ansprüche, **dadurch gekennzeichnet, dass** die Erhitzungsstufe in einer Inertgasatmosphäre durchgeführt wird, deren Gehalte an Wasser und an Sauerstoff derart sind, dass die Summe der Wasser- und der Sauerstoffmasse in der Gasatmosphäre weniger als gewichtsmäßige 200 ppm beträgt.

13. Verfahren nach dem vorhergehenden Anspruch, **dadurch gekennzeichnet, dass** der Wassergehalt der inerten Atmosphäre gewichtsmäßige 10 bis 180 ppm und der Sauerstoffgehalt der Atmosphäre gewichtsmäßige 0,5 bis 2 ppm beträgt.

14. Verfahren nach einem der vorhergehenden Ansprüche, **dadurch gekennzeichnet, dass** die NH₄X-Menge mindestens die Summe der zwei folgenden Mengen ist:
A) eine Molzahl von NH₄X, die gleich dem Einfachen der Molzahl des nicht mit Sauerstoff verbundenen Ln ist, und
B) eine Molzahl von NH₄X, die gleich dem Dreifachen der Molzahl der mit Ln verbundenen Sauerstoffatome ist.

15. Verfahren nach dem vorhergehenden Anspruche, **dadurch gekennzeichnet, dass** die NH₄X-Menge mindestens die Summe der zwei folgenden Mengen ist:
A) eine Molzahl von NH₄X, die gleich dem Dreifachen der Molzahl von nicht mit Sauerstoff verbundenem Ln ist, und
B) eine Molzahl von NH₄X, die gleich dem Fünffachen der Molzahl der mit Ln verbundenen Sauerstoffatome ist.

16. Verfahren nach einem der vorhergehenden Ansprüche, **dadurch gekennzeichnet, dass** die Erhitzungsstufe in einem Tiegel durchgeführt wird, der von einem Material gebildet ist, das mindestens 20 Gew.-% Kohlenstoff umfasst.

17. Verfahren nach dem vorhergehenden Anspruch, **dadurch gekennzeichnet, dass** der Tiegel aus Kohlenstoff, glasartigem Kohlenstoff oder Graphit besteht.

18. Verfahren nach einem der zwei vorhergehenden Ansprüche, **dadurch gekennzeichnet, dass** der Tiegel mit einer Schicht aus Pyrokohlenstoff überzogen ist.

19. Polykristalliner Block aus mindestens 1 g Halogenid mit der Formel AₑLn_{f}X_{(3f+e)}, in welcher Ln ein oder mehrere Seltenerdmetalle, X ein oder mehrere Halogenatome, die aus Cl, Br oder I ausgewählt sind, und A ein oder mehrere Alkalimetalle wie K, Li, Na, Rb oder Cs bedeutet und e und f solche Werte bedeuten, dass
- e, das Null sein kann, weniger als oder gleich 3f und
- f mehr als oder gleich 1 beträgt,
und welches weniger als 0,1 Gew.-% Wasser und weniger als 0,2 Gew.-% Seltenerdmetallhalogenidoxid enthält.

20. Block nach dem vorhergehenden Anspruch, **dadurch gekennzeichnet, dass** er weniger als 0,1 Gew.-% Seltenerdmetallhalogenidoxid enthält.

21. Block nach dem vorhergehenden Anspruch, **dadurch gekennzeichnet, dass** er weniger als 0,05 Gew.-% Seltenerdmetallhalogenidoxid enthält.

22. Block nach dem vorhergehenden Anspruch, **dadurch gekennzeichnet, dass** er weniger als 0,02 Gew.-% Seltenerdmetallhalogenidoxid enthält.

23. Block nach einem der ihn betreffenden vorhergehenden Ansprüche, **dadurch gekennzeichnet, dass** er mindestens 10 g wiegt.

24. Block nach dem vorhergehenden Anspruch, **dadurch gekennzeichnet, dass** er mindestens 50 g wiegt.

25. Block nach einem der ihn betreffenden vorhergehenden Ansprüche, **dadurch, gekennzeichnet, dass** er eine scheinbare Dichte von mindestens 75 % der theoretischen Dichte, die demselben Material, das frei von Porositäten ist, entspricht, aufweist.

26. Block nach einem der ihn betreffenden vorhergehenden Ansprüche, **dadurch gekennzeichnet, dass** Ln La oder Ce und X Cl oder Br bedeutet.

27. Block nach einem der ihn betreffenden vorhergehenden Ansprüche, **dadurch gekennzeichnet, dass** keins seiner Körner mehr als 10 % der Masse des gesamten Blocks ausmacht.

28. Verfahren nach einem der Ansprüche 1 bis 18, **dadurch gekennzeichnet, dass** der Block einer von denjenigen der Ansprüche 19 bis 27 ist.

29. Verwendung von mindestens einem Block nach einem der ihn betreffenden vorhergehenden Ansprüche zur Herstellung eines Kristalls, die das Schmelzen des Blocks umfasst.

30. Verwendung nach dem vorhergehenden Anspruch, **dadurch gekennzeichnet, dass** der Kristall ein Einkristall ist.

31. Einkristall mit der Formel AₑLn_{f}X_{(3f+e)}, in welcher Ln ein oder mehrere Seltenerdmetalle, X ein oder mehrere Halogenatome, die aus Cl, Br oder I ausgewählt sind, und A ein oder mehrere Alkalimetalle wie K, Li, Na, Rb oder Cs bedeutet und e und f solche Werte bedeuten, dass
- e, das gleich Null sein kann, weniger als oder gleich 3f und
- f mehr als oder gleich 1 beträgt,
und welcher weniger als 0,1 Gew.-% Seltenerdmetallhalogenidoxid enthält.

32. Einkristall nach dem vorhergehenden Anspruch, **dadurch gekennzeichnet, dass** sein Halogenidoxidgehalt weniger als 0,05 Gew.-% beträgt.

33. Einkristall nach dem vorhergehenden Anspruch, **dadurch gekennzeichnet, dass** sein Halogenidoxidgehalt weniger als 0,02 Gew.-% beträgt.

34. Einkristall nach einem der ihn betreffenden vorhergehenden Ansprüche, **dadurch gekennzeichnet, dass** Ln aus La, Gd, Y, Lu und Ce und X aus Cl und Br ausgewählt ist.

35. Einkristall nach einem der ihn betreffenden vorhergehenden Ansprüche, **dadurch gekennzeichnet, dass** sein Volumen mindestens 10 cm³ beträgt.

36. Einkristall nach einem der ihn betreffenden vorhergehenden Ansprüche, **dadurch gekennzeichnet, dass** seine Lichtausbeute mindestens 90 % derjenigen eines Kristalls aus NaI, das mit gewichtsmäßigen 600 ppm T1-Iodid dotiert ist, dessen Energieauflösung bei 622 keV 6,8 % und dessen Integrationszeit 1 µs und die radioaktive Quelle Cs 137 mit 622 keV ist, beträgt.

37. Einkristall nach einem der ihn betreffenden vorhergehenden Ansprüche, **dadurch gekennzeichnet, dass** seine Energieauflösung weniger als 5 % beträgt.

38. Einkristall nach dem vorhergehenden Anspruch, **dadurch gekennzeichnet, dass** seine Energieauflösung weniger als 4 % beträgt.

39. Einkristall nach dem vorhergehenden Anspruch, **dadurch gekennzeichnet, dass** seine Energieauflösung weniger als 3,5 % beträgt.

40. Einkristall nach einem der ihn betreffenden vorhergehenden Ansprüche, **dadurch gekennzeichnet, dass** die Abklingzeit der Hauptkomponente weniger als 40 Nanosekunden beträgt.

41. Einkristall nach dem vorhergehenden Anspruch, **dadurch gekennzeichnet, dass** die Abklingzeit der Hauptkomponente weniger als 30 Nanosekunden beträgt.

42. Einkristall nach dem vorhergehenden Anspruch, **dadurch gekennzeichnet, dass** die Abklingzeit der Hauptkomponente weniger als 20 Nanosekunden beträgt.
